# EUROPEAN PATENT APPLICATION

(11) **EP 4 657 886 A1**
(43) Date of publication of application: **03.12.2025**
(21) Application number: 25179829.4
(22) Date of filing: 30.05.2025
(51) Int. Cl.: H04R 3/00, H02J 1/08, H02J 1/14, H02J 7/00, H02J 7/34, H02J 9/00

(54) **SOUND SIGNAL OUTPUT DEVICE AND SOUND SIGNAL OUTPUT METHOD**

(30) Priority: 31.05.2024 JP 2024088564
(71) Applicant: YAMAHA CORPORATION, Hamamatsu-shi, Shizuoka 430-8650 (JP)
(72) Inventor: MASUDA, Naoto, Hamamatsu-shi, Shizuoka, 430-8650 (JP); HANDA, Takashi, Hamamatsu-shi, Shizuoka, 430-8650 (JP)
(74) Representative: Hoffmann Eitle

(57) **Abstract**

A sound signal output device includes: a charger configured to control charging of a secondary battery using an input power from an external power supply; and a switch configured to switch a power source of an amplifier, the amplifier being configured to amplify a sound signal, to select either the external power supply or the secondary battery. The switch is configured to switch the power source from the external power supply to the secondary battery in response to the input power exceeding a predetermined power due to an increase in power consumption of the amplifier in a state in which the external power supply is selected as the power source.

## Description

### FIELD

The present disclosure relates to a sound signal output device and a sound signal output method.

### BACKGROUND

For example, there is a sound signal output device that amplifies a sound signal such as a performance signal of a musical instrument or a voice signal from a microphone and outputs the sound signal to a speaker so that a street performance, a speech, or the like can be performed anytime and anywhere. In the sound signal output device, a small and lightweight external power supply such as an AC adapter is often used as a power supply in order to reduce a weight for convenience of carrying.

In the sound signal output device, since an input is the sound signal, a high output may occur instantaneously. When an instantaneous high output occurs and power consumption of the sound signal output device exceeds the capability of the external power supply, the external power supply may become unable to output a power. On the other hand, an average power consumed in the sound signal output device is smaller than the above-described instantaneous high output.

For this reason, there is a technique in which a sound signal output device has a configuration capable of coping with an instantaneous high output, rather than determining a rated output of an external power supply in accordance with the instantaneous high output (see, for example, JP2016-178843A). Specifically, in this technique, when it is detected that power consumption of the sound signal output device exceeds an upper limit value of a power that can be supplied from a power supply, a power stored in advance in a capacitor is supplied to a load.

### SUMMARY

However, in the technique described in JP2016-178843A, since the power that can be stored in the capacitor is limited, there is a problem that it is not possible to cope with a case where frequency at which the power consumption of the sound signal output device exceeds the upper limit value of the power that can be supplied from the external power supply is high.

An aspect of the present disclosure provides a sound signal output device including: a charger configured to control charging of a secondary battery using an input power from an external power supply; and a switch configured to switch a power source of an amplifier, the amplifier being configured to amplify a sound signal, to select either the external power supply or the secondary battery, in which in response to the input power exceeding a predetermined power due to an increase in power consumption of the amplifier in a state in which the external power supply is selected as the power source, the switch is configured to switch the power source from the external power supply to the secondary battery.

Another aspect of the present disclosure provides a sound signal output method for controlling charging of a secondary battery using an input power from an external power supply and switching a power source of an amplifier, the amplifier being configured to amplify a sound signal, to select either the external power supply or the secondary battery, the sound signal output method including: switching the power source from the external power supply to the secondary battery in response to the input power exceeding a predetermined power due to an increase in power consumption of the amplifier in a state in which the external power supply is selected as the power source.

### BRIEF DESCRIPTION OF DRAWINGS

The present disclosure will be described in detail based on the following without being limited thereto.
FIG. 1 is a diagram illustrating a configuration of a system including a sound signal output device according to a first embodiment;
FIG. 2 is a flowchart illustrating operations of the sound signal output device;
FIG. 3 is a flowchart illustrating operations of the sound signal output device;
FIG. 4 is a flowchart illustrating operations of the sound signal output device;
FIG. 5 is a diagram illustrating switching of power supply in a normal operation mode;
FIG. 6 is a diagram illustrating switching of charging in an output limit mode;
FIG. 7 is a diagram illustrating a remaining amount of a secondary battery;
FIG. 8 is a diagram illustrating a configuration of a system including a sound signal output device according to a second embodiment;
FIG. 9 is a diagram illustrating a configuration of a system including a sound signal output device according to a third embodiment;
FIG. 10 is a diagram illustrating a configuration of a system including a sound signal output device according to a modification; and
FIG. 11 is a diagram illustrating displayed remaining lives of a secondary battery in the sound signal output device according to the modification.

### DETAILED DESCRIPTION

Hereinafter, sound signal output devices according to embodiments of the present disclosure will be described with reference to the drawings. Since the embodiments described below are preferred specific examples, various technically preferable limitations are given, but the scope of the present disclosure is not limited to these embodiments unless otherwise stated to limit the present disclosure in the following description.

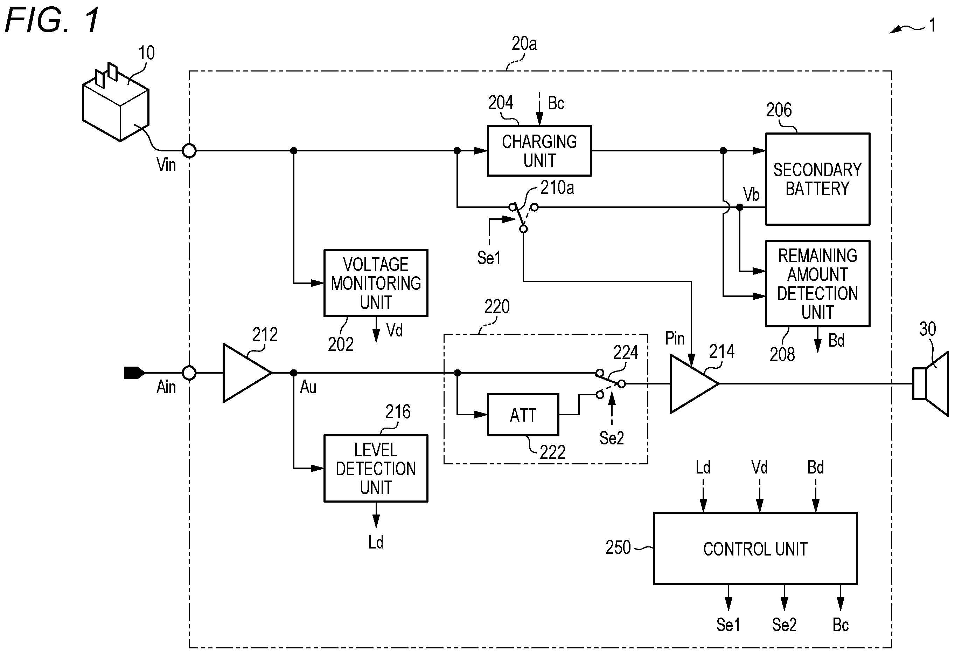

FIG. 1 is a block diagram illustrating a configuration of a system 1 including a sound signal output device 20a according to a first embodiment. The sound signal output device 20a is a device that amplifies a sound signal Ain and outputs the amplified sound signal from a speaker 30.

An AC adapter 10 is an example of an external power supply that converts an alternating current of a commercial power supply into a direct current and supplies the direct current to the sound signal output device 20a. In the present embodiment, a rated output of the AC adapter 10 is, for example, 24 V, 2.5 A (= 60 W).

The sound signal Ain is an acoustic signal output from a microphone, an electric musical instrument, or a reproduction device.

The speaker 30 converts an amplified sound signal into a sound that is physical vibration and outputs the sound.

In FIG. 1, the speaker 30 is a so-called full-range type speaker in which a sound range from a low frequency to a high frequency is reproduced by one unit, but may be a multi-way unit in which speaker units are divided for each frequency band.

In FIG. 1, the sound signal output device 20a and the speaker 30 are separated for convenience of description, but the sound signal output device 20a and the speaker 30 may be accommodated in one housing.

The sound signal output device 20a includes a voltage monitoring unit 202, a charging unit 204, a secondary battery 206, a remaining amount detection unit 208, a switching unit 210a, a head amplifier 212, a power amplifier 214, a level detection unit 216, an attenuation unit 220, and a control unit 250.

The voltage monitoring unit 202 monitors a voltage Vin input from the AC adapter 10 and outputs a signal Vd indicating a voltage monitoring result.

The charging unit 204 controls, based on a signal Bc, charging of the secondary battery 206 using the voltage Vin. More specifically, the charging unit 204 controls the charging of the secondary battery 206 so that, for example, the secondary battery 206 is not charged, charged at a low speed, or charged at a high speed.

The secondary battery 206 is a storage battery that can be repeatedly charged and discharged. As the secondary battery 206, for example, a lithium ion battery is preferable.

The remaining amount detection unit 208 detects an amount of charge remaining in the secondary battery 206, that is, a battery remaining amount, based on a charging current, a voltage, a temperature, and the like, and outputs a signal Bd indicating a detection result.

The switching unit 210a is a double-throw switch circuit that selects one end or the other end in accordance with a signal Se1. If the AC adapter 10 is connected, the voltage Vin is applied to one end, and a voltage Vb output from the secondary battery 206 is applied to the other end of the switching unit 210a. The switching unit 210a selects either the voltage Vin or the voltage Vb and applies the selected voltage to a power supply input terminal Pin of the power amplifier 214. Therefore, the switching unit 210a switches a power source of the power amplifier 214 to select either the voltage Vin or the voltage Vb.

The head amplifier 212 amplifies the sound signal Ain to a line level or converts the sound signal Ain to a lower impedance, and outputs the sound signal Ain as a sound signal Au.

The level detection unit 216 detects a level of the sound signal Au and outputs a signal Ld indicating a detection result. The level of the sound signal Au is, for example, an amplitude effective value of a sound signal. Although the level detection unit 216 directly detects the level of the sound signal Au, since an amplification factor of the head amplifier 212 is fixed, the level detection unit 216 indirectly detects a level of the sound signal Ain.

The attenuator 220 selects either the sound signal Au or a signal obtained by attenuating the sound signal Au, and supplies the selected signal to an input terminal of the power amplifier 214. Specifically, the attenuation unit 220 includes an attenuator (ATT) 222 and a switch 224. The attenuator 222 attenuates the sound signal Au by, for example, 5 dB. The switch 224 selects either the sound signal Au or an attenuation signal obtained by the attenuator 222 in accordance with a signal Se2 and supplies the selected signal to the input terminal of the power amplifier 214.

The power amplifier 214 amplifies the signal output from the attenuation unit 220 using the voltage selected by the switching unit 210a as a power source, and supplies the amplified signal to the speaker 30.

The control unit 250 includes, for example, one or more processing circuits such as a digital signal processor (DSP), and controls the switching unit 210a, the charging unit 204, and the switch 224 based on the signals Vd, Bd, and Ld.

Specifically, the control unit 250 outputs the signal Se1 for controlling the switching unit 210a based on the signal Vd indicating the monitoring result of the voltage Vin. The control unit 250 outputs the signal Bc for controlling the charging unit 204 based on the signal Bd indicating the detection result of the battery remaining amount and the signal Ld indicating the level detection result of the sound signal Au, and outputs a signal Se2 for controlling the switch 224 based on the signal Ld.

In addition to the DSP, the control unit 250 may include a circuit such as a central processing unit (CPU) or an application specific integrated circuit (ASIC).

Next, an operation of the sound signal output device 20a will be described.

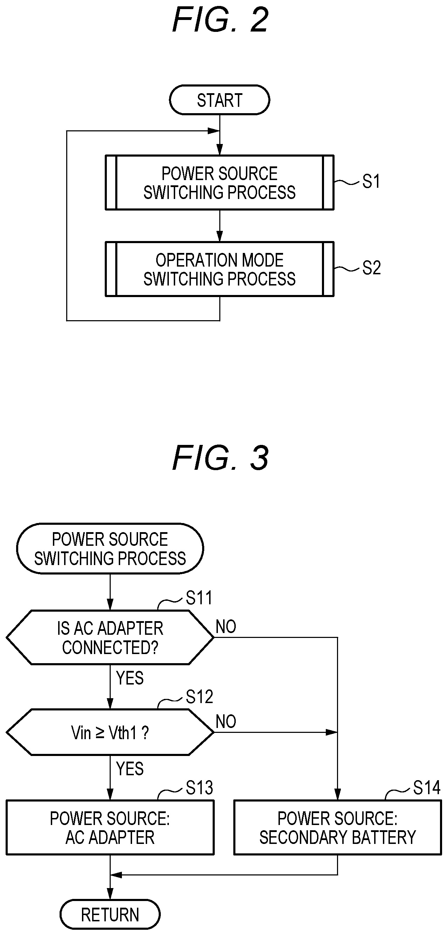

FIGS. 2 to 4 are each a flowchart illustrating an example of operations of the sound signal output device 20a. The control unit 250 executes processes illustrated in FIG. 2 at regular intervals (for example, 100 ms).

First, when a power supply switch (not illustrated) is turned on, the control unit 250 executes a power source switching process (step S1), and then executes an operation mode switching process (step S2). After the operation mode switching process is executed, a processing procedure returns to the step S1 again. That is, in the sound signal output device 20a, when the power supply switch is turned on, the power source switching process and the operation mode switching process are repeatedly executed.

FIG. 3 is a flowchart illustrating an example of the power source switching process in the step S1.

First, the control unit 250 determines whether the AC adapter 10 is connected to the sound signal output device 20a (step S11).

Whether the AC adapter 10 is connected to the sound signal output device 20a is detected by, for example, determining whether an output plug of the AC adapter 10 is inserted into an input jack of the sound signal output device 20a.

If the AC adapter 10 is connected (if a determination result in the step S11 is "Yes"), the control unit 250 determines whether the voltage Vin is equal to or larger than a threshold voltage Vthl based on the signal Vd (step S12).

The threshold voltage Vthl is a voltage used as a reference for determining whether a total power consumed by the sound signal output device 20a exceeds a threshold power. Specifically, the threshold voltage Vthl is set to a voltage that is smaller than a lower limit value of a rated output voltage of the AC adapter 10 and is equal to or larger than a voltage at which a protection circuit incorporated in the AC adapter 10 operates. The "protection circuit" is a circuit that blocks an output of an external power supply to protect the external power supply. When the rated output voltage of the AC adapter 10 is 24 V ± 5%, the lower limit value of the rated output voltage is 22.8 V In addition, when a power consumed by the sound signal output device 20a increases and continuously exceeds a rated output power of the AC adapter 10, an output voltage of the AC adapter 10 (a voltage Vin output from the AC adapter 10) decreases, and the protection circuit operates. For example, when the output voltage of the AC adapter 10 is smaller than 20.0 V, the protection circuit of the AC adapter 10 operates. In such a case, the threshold voltage Vthl is set to a voltage in a range of 20.0 V or more and 22.8 V or less. When the threshold voltage Vth1 is set to the voltage in such a range, it is possible to reliably prevent the protection circuit of the AC adapter 10 from operating (that is, the AC adapter 10 from becoming unable to output) while accurately determining that the output voltage of the AC adapter 10 is smaller than the rated output voltage.

If the voltage Vin is equal to or larger than the threshold voltage Vth1 (if a determination result in the step S12 is "Yes"), it is determined that the total power consumed by the sound signal output device 20a does not exceed the threshold power. Therefore, the control unit 250 outputs, to the switching unit 210a, the signal Se1 for selecting the voltage Vin as the power source of the power amplifier 214 (step S13).

Accordingly, in the switching unit 210a, one end is selected, and therefore, the power source of the power amplifier 214 has the voltage Vin output from the AC adapter 10.

On the other hand, a fact that the voltage Vin is smaller than the threshold voltage Vthl means that the total power consumed by the sound signal output device 20a exceeds the threshold power, or that some trouble occurs in the AC adapter 10 (for example, the AC adapter 10 is not normal). In any case, the fact that the voltage Vin is smaller than the threshold voltage Vthl means that the sound signal Au cannot be amplified when the voltage Vin output from the AC adapter 10 is used as the power source of the power amplifier 214.

Therefore, if the AC adapter 10 is not connected (if a determination result in the step S11 is "No") or if the voltage Vin is smaller than the threshold voltage Vthl (if the determination result in the step S12 is "No"), the control unit 250 outputs, to the switching unit 210a, the signal Se1 for selecting the voltage Vb from the secondary battery 206 as the power source of the power amplifier 214 (step S14).

Accordingly, in the switching unit 210a, the other end is selected, and therefore, the power source of the power amplifier 214 has the voltage Vb output from the secondary battery 206.

After the process of either step S13 or S14 is executed, the control unit 250 executes the next operation mode switching process.

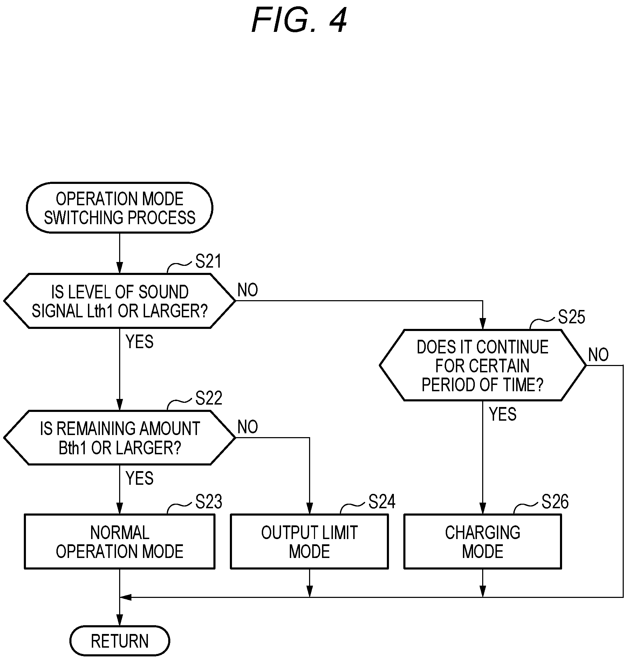

FIG. 4 is a flowchart illustrating an example of the operation mode switching process in the step S2.

First, the control unit 250 determines whether the level of the sound signal Au in the level detection result of the sound signal Au indicated by the signal Ld is equal to or larger than a threshold level Lth1 (step S21). The threshold level Lth1 is a level at the time when there is no sound signal Au that needs to be output from the speaker 30, and is set to, for example, zero or a noise floor level.

If the level of the sound signal Au is equal to or larger than the threshold level Lth1 (if a determination result in the step S21 is "Yes"), the control unit 250 determines whether a battery remaining amount indicated by the signal Bd is equal to or larger than a threshold remaining amount Bth1 (step S22). The threshold remaining amount Bth1 is, for example, an amount indicating that the battery remaining amount is 10%.

A fact that the level of the sound signal Au is equal to or larger than the threshold level Lth1 means that the sound signal Au needs to be output from the speaker 30, and a fact that the battery remaining amount is equal to or larger than the threshold remaining amount Bth1 means that the secondary battery 206 does not need to be charged.

Therefore, if the level of the sound signal Au is equal to or larger than the threshold level Lth1 (the determination result in the step S21 is "Yes") and the battery remaining amount is equal to or larger than the threshold remaining amount Bth1 (if a determination result in the step S22 is "Yes"), the control unit 250 sets an operation mode to a normal operation mode (step S23).

The normal operation mode is a mode in which the sound signal Au, which is an output of the head amplifier 212, is amplified by the power amplifier 214 without being attenuated by the attenuator 222 and is output from the speaker 30, and is a mode in which the secondary battery 206 is not charged.

In order to set the operation mode to the normal operation mode, the control unit 250 outputs, to the switch 224, a signal Se2 for selecting the sound signal Au, and outputs, to the charging unit 204, a signal Bc for stopping charging the secondary battery 206.

If the level of the sound signal Au is equal to or larger than the threshold level Lth1 (the determination result in the step S21 is "Yes"), but the battery remaining amount is smaller than the threshold remaining amount Bth1 (if the determination result in the step S22 is "No"), the control unit 250 sets the operation mode to an output limit mode (step S24).

The output limit mode is a mode in which the secondary battery 206 is charged at a low speed while the sound signal Au is attenuated by the attenuator 222 and then amplified by the power amplifier 214.

In order to set the operation mode to the output limit mode, the control unit 250 outputs, to the switch 224, the signal Se2 for selecting the attenuation signal obtained by the attenuator 222, and outputs, to the charging unit 204, the signal Bc for charging the secondary battery 206 at a low speed.

Specifically, a transition to the output limit mode is likely to occur in a state in which a remaining amount of the secondary battery 206 decreases because the system 1 is continuously used for a relatively long time. As an application of the system 1 continuously used for a relatively long time, for example, an application of playing BGM is assumed. When the operation mode transitions to the output limit mode, the sound signal Au is attenuated by 5 dB by the attenuator 222 and supplied to the power amplifier 214. However, in such an application, a decrease in volume due to attenuation of 5 dB is less noticeable. Therefore, in the output limit mode, there is a great advantage in that the sound signal Au can continue to be output from the speaker 30 while the secondary battery 206 is charged.

On the other hand, if the level of the sound signal Au is smaller than the threshold level Lth1 (if the determination result in the step S21 is "No"), the control unit 250 determines whether a state in which the level of the sound signal Au is smaller than the threshold level Lth1 has continued for a certain period of time (for example, 5 seconds) (step S25).

The operation mode is maintained in the normal operation mode or the output limit mode until the state in which the level of the sound signal Au is smaller than the threshold level Lth1 continues for a certain period of time.

If the state in which the level of the sound signal Au is smaller than the threshold level Lth1 continues, a certain period of time elapses while determinations in the steps S21 and S25 are repeated, and a determination result in the step S25 becomes "Yes". If the determination result in the step S25 is "Yes", the control unit 250 sets the operation mode to a charging mode (step S26).

The charging mode is a mode in which amplification of the sound signal Au is stopped and the secondary battery 206 is charged at a high speed.

In order to set the operation mode to the charging mode, the control unit 250 outputs, to the charging unit 204, the signal Bc for charging the secondary battery 206 at a high speed. In order to set the operation mode to the charging mode, the control unit 250 may stop an operation of the head amplifier 212 by, for example, a function (not illustrated). Accordingly, a target to be amplified is lost, and therefore, a power consumed by the power amplifier 214 becomes zero, and the speaker 30 enters a silent state.

In the sound signal output device 20a, elements other than the power amplifier 214 continue to consume a power.

After the steps S23, S24, and S26 are completed, or if the determination result in the step S25 is "No", the control unit 250 ends the operation mode switching process, and returns the processing procedure to the step S1.

In this way, the processes of steps S1 and S2 are repeatedly executed.

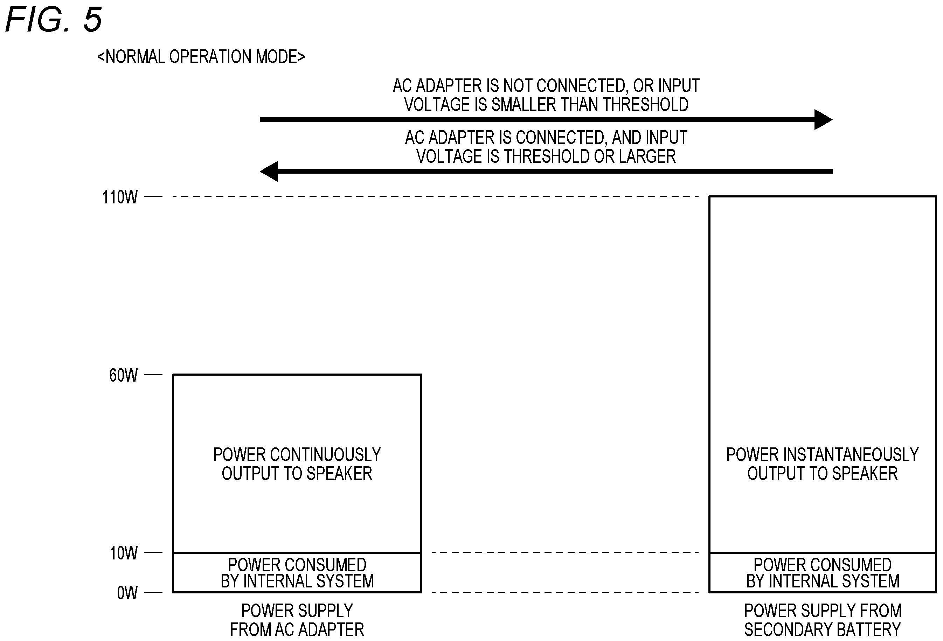

Next, a specific example of the above-described power source switching process will be described. FIG. 5 is a diagram illustrating switching of the power source in the normal operation mode.

As described above, when the AC adapter 10 is connected to the sound signal output device 20a and the voltage Vin output from the AC adapter 10 is equal to or larger than the threshold voltage Vth1, the power source of the power amplifier 214 becomes the AC adapter 10.

The total power consumed by the sound signal output device 20a can be divided into the power consumed by the power amplifier 214 and the power consumed by the elements other than the power amplifier 214.

The power consumed by the power amplifier 214 varies depending on the level of the sound signal Au. The elements other than the power amplifier 214 include the voltage monitoring unit 202, the remaining amount detection unit 208, the head amplifier 212, the level detection unit 216, the control unit 250, and the like, and the power consumed by these elements does not vary depending on the level of the sound signal Au and is substantially constant. In FIG. 5, the elements other than the power amplifier 214 are referred to as an internal system. The power consumed by the internal system is, for example, 10 W.

As described above, the rated output of the AC adapter 10 is 60 W. When the power consumed by the power amplifier 214, that is, the power continuously output to the speaker 30 is 50 W or less, the total power, including the 10 W of power consumed by the internal system, is 60 W or less, and therefore, the power source of the power amplifier 214 becomes the AC adapter 10.

On the other hand, when the AC adapter 10 is connected to the sound signal output device 20a and the power source is the AC adapter 10, if a power output to the speaker 30 instantaneously exceeds 50 W, the total power consumed by the sound signal output device 20a exceeds the rated output power of the AC adapter 10, and the voltage Vin becomes smaller than the threshold voltage Vthl. Therefore, the power source of the power amplifier 214 is switched from the AC adapter 10 to the secondary battery 206, and the sound signal Au continues to be output from the speaker 30.

A right column of FIG. 5 is an example in which the power output to the speaker 30 instantaneously becomes 100 W, and the total power consumed by the sound signal output device 20a exceeds 60 W which is the rated output power of the AC adapter 10.

In addition, in a case in which the voltage Vin becomes smaller than the threshold voltage Vthl and the power source of the power amplifier 214 is the secondary battery 206, when the voltage Vin recovers to the threshold voltage Vth1 or more, the power source of the power amplifier 214 is switched from the secondary battery 206 to the AC adapter 10.

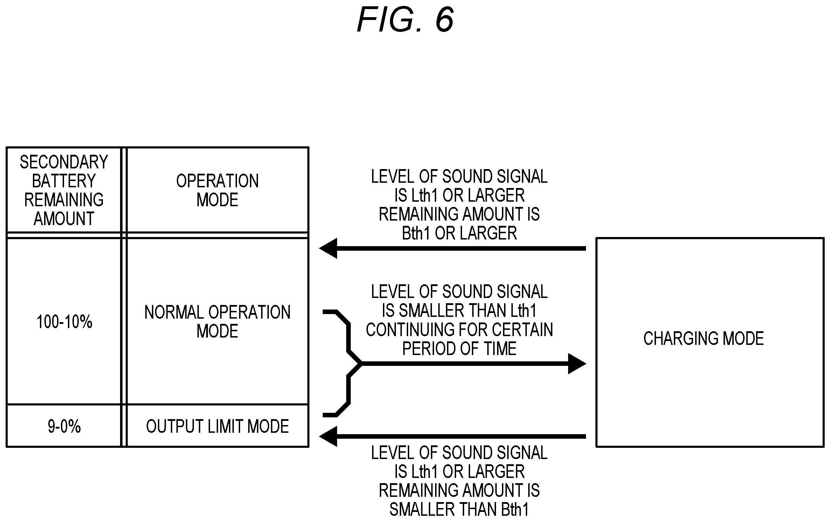

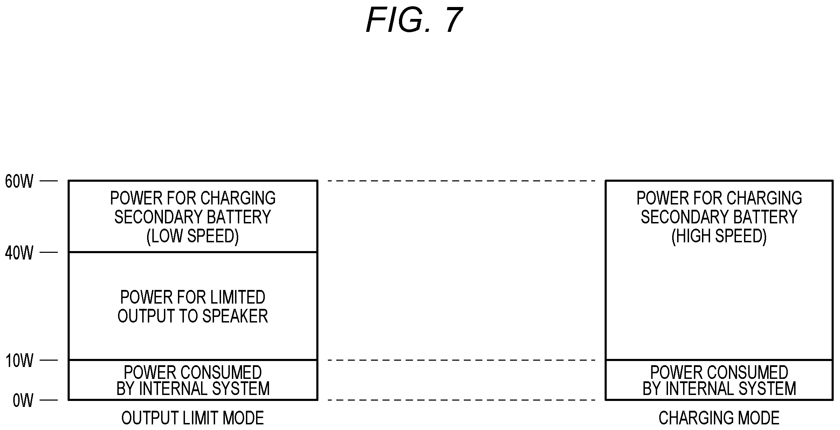

Next, a specific example of the above-described operation mode switching process will be described. FIG. 6 is a diagram illustrating a transition of the operation mode, and FIG. 7 is a diagram illustrating allocation of a power in the output limit mode and allocation of a power in the charging mode.

As described above, when the level of the sound signal Au is equal to or larger than the threshold level Lth1 and the battery remaining amount is equal to or larger than the threshold remaining amount Bth1, the operation mode becomes the normal operation mode. When the level of the sound signal Au is equal to or larger than the threshold level Lth1 and the battery remaining amount is smaller than the threshold remaining amount Bth1, the operation mode becomes the output limit mode.

A left column of FIG. 7 is a diagram illustrating the allocation of the power executed by the AC adapter 10 in the output limit mode.

In the output limit mode, due to the attenuation of 5 dB executed by the attenuator 222, an output of the power amplifier 214 decreases from 100 W to 30 W, for example. In this case, since the power consumed by the internal system is 10 W, there is a margin of 20 W up to the rated output power of the AC adapter 10. In the present embodiment, this 20 W of power is used to charge the secondary battery 206.

In the output limit mode, since the sound signal Au is attenuated by 5 dB by the attenuator 222 and input into the power amplifier 214, in a state in which the power consumed by the power amplifier 214 decreases, the sound signal Au continues to be output from the speaker 30, and the secondary battery 206 in the state in which the remaining amount decreases is charged.

In a case in which the operation mode is the normal operation mode or the output limit mode, when the state in which the level of the sound signal Au is smaller than the threshold level Lth1 continues for a certain period of time, the operation mode transitions to the charging mode.

A right column of FIG. 7 is a diagram illustrating the allocation of the power executed by the AC adapter 10 in the charging mode.

In the charging mode, regarding the rated output power of the AC adapter 10, 10 W of the power consumed by the internal system is secured, and the remaining 50 W of power is used to charge the secondary battery 206. Therefore, in the charging mode, the secondary battery 206 is charged at a higher speed than in the output limit mode.

In a case in which the operation mode is the charging mode, when the level of the sound signal Au is equal to or larger than the threshold level Lthl, the operation mode transitions to the output limit mode when the battery remaining amount is smaller than the threshold remaining amount Bth1, and the operation mode transitions to the normal operation mode when the battery remaining amount is equal to or larger than the threshold remaining amount Bth1.

In addition, in the output limit mode, since the power that can be used for charging the secondary battery 206 is smaller than that in the charging mode, the secondary battery 206 is charged at a relatively lower speed, that is, at a lower speed than that in the charging mode.

In the first embodiment, when power consumption of the sound signal output device 20a exceeds a power that can be supplied from the AC adapter 10, the power source of the power amplifier 214 is switched to the secondary battery 206, and therefore, the power amplifier 214 can continuously amplify the sound signal Au.

In the first embodiment, a transition condition from the normal operation mode or the output limit mode to the charging mode is that the state in which the level of the sound signal Au is smaller than the threshold level Lth1 continues for a certain period of time. The present disclosure is not limited to this, when the level of the sound signal Au is smaller than the threshold level Lthl, the operation mode may immediately transition to the charging mode without continuing for a certain period of time.

The transition condition to the charging mode may be that the level of the sound signal Au is smaller than the threshold level Lth1 (or this state continues for a certain period of time) and the remaining amount of the secondary battery 206 is smaller than the threshold remaining amount Bth2. That is, when the level of the sound signal Au is smaller than the threshold level Lth1 and the battery remaining amount is smaller than the threshold remaining amount Bth2, the operation mode may transition to the charging mode, and when the battery remaining amount is equal to or larger than the threshold remaining amount Bth2, the operation mode may not transition to the charging mode. According to this configuration, even when the level of the sound signal Au is smaller than the threshold level Lthl, when the battery remaining amount is equal to or larger than the threshold remaining amount Bth2 (that is, when the battery remaining amount is sufficient to some extent), the operation mode does not transition to the charging mode, and therefore, the number of times of charging decreases, thereby preventing deterioration of the secondary battery 206.

The threshold remaining amount Bth2 may be, for example, an amount indicating that the battery remaining amount is 10% as with the threshold remaining amount Bth1, but may be an amount different from the threshold remaining amount Bth1 from a viewpoint of preventing the deterioration of the secondary battery 206.

In the first embodiment, it is determined that the total power consumed by the sound signal output device 20a exceeds the threshold power when the voltage Vin is equal to or larger than the threshold voltage Vth1, but this determination may be made based on something other than the voltage Vin.

As described above, the total power consumed by the sound signal output device 20a can be divided into the power consumed by the power amplifier 214 and the power consumed by the internal system, and the power consumed by the power amplifier 214 varies depending on the level of the sound signal Au. In other words, by detecting the level of the sound signal Au, the total power consumed by the sound signal output device 20a can be estimated.

Therefore, when the level of the sound signal Au is equal to or larger than the threshold level Lth2, it may be determined that the total power consumed by the sound signal output device 20a exceeds the threshold power. The threshold level Lth2 is a level used as a reference for determining whether the total power consumed by the sound signal output device 20a exceeds the threshold power. For example, the level of the sound signal Au corresponding to a case in which the voltage Vin is the threshold voltage Vthl may be set as the threshold level Lth2.

When the voltage Vin is equal to or larger than a threshold voltage Vth2, the control unit 250 may cause the charging unit 204 to charge the secondary battery 206. That is, when the voltage Vin has a margin, the secondary battery 206 may be used as the power source of the power amplifier 214 while being charged.

In this configuration, since a state in which the power consumed by the power amplifier 214 is small is preferable, a charging condition of the secondary battery 206 may also include a condition that the level of the sound signal Au is smaller than a threshold level (for example, the threshold level Lth1) in addition to the condition that the voltage Vin is equal to or larger than the threshold voltage Vth2.

The threshold voltage Vth2 is set to a voltage that can be used as the power source of the power amplifier 214 while charging the secondary battery 206 with the voltage Vin.

In addition, the transition condition from the normal operation mode or the output limit mode to the charging mode is that the level of the sound signal Au is smaller than the threshold level Lth1 (or this state continues for a certain period of time), but when the voltage Vin is equal to or larger than the threshold voltage Vth2, the operation mode may transition to the charging mode.

Next, a sound signal output device 20b according to a second embodiment and a sound signal output device 20c according to a third embodiment will be described in order.

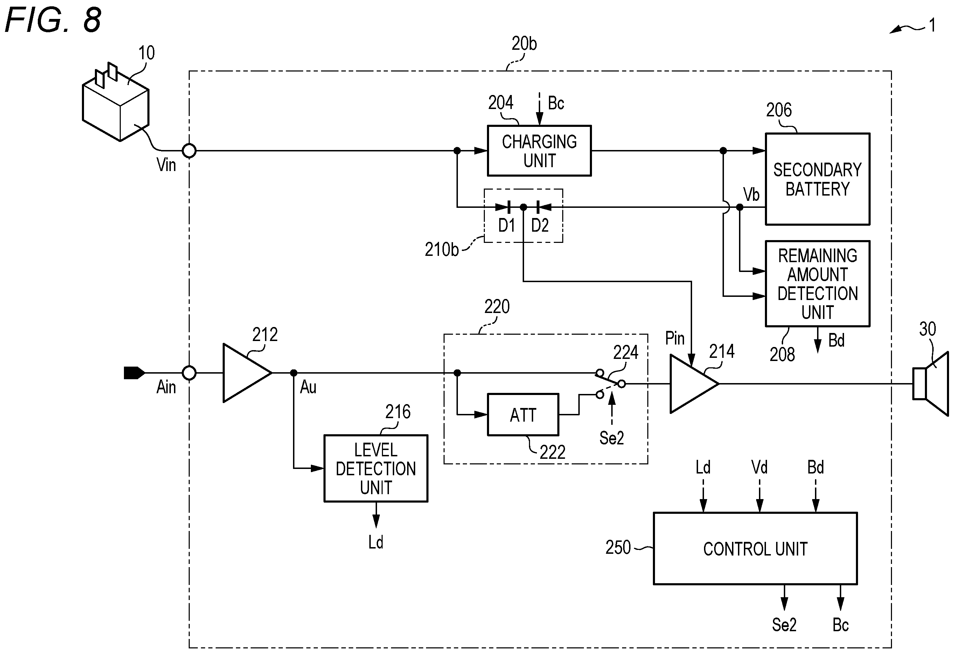

FIG. 8 is a block diagram illustrating a configuration of the system 1 including the sound signal output device 20b according to the second embodiment. The sound signal output device 20b is different from the sound signal output device 20a according to the first embodiment in that the switching unit 210a is replaced with a switching unit 210b, the voltage monitoring unit 202 is not provided, and the control unit 250 does not output the signal Se1.

In the second embodiment, the switching unit 210b is a so-called diode OR circuit. Specifically, the switching unit 210b includes a diode D1 whose forward direction is a direction from an input jack into which the output plug of the AC adapter 10 is inserted toward the power supply input terminal Pin of the power amplifier 214, and a diode D2 whose forward direction is a direction from an output terminal of the secondary battery 206 toward the power supply input terminal Pin.

In the switching unit 210b, when the voltage Vin output from the AC adapter 10 is larger than the voltage Vb output from the secondary battery 206, the voltage Vin becomes the power source of the power amplifier 214, and when the voltage Vb is larger than the voltage Vin, the voltage Vb becomes the power source of the power amplifier 214.

As described above, in the switching unit 210b, the power source of the power amplifier 214 is automatically switched in accordance with the level of the voltage Vin or the voltage Vb. Therefore, in the second embodiment, since the voltage monitoring unit 202 that monitors the voltage Vin is unnecessary, the configuration can be simplified as compared with the first embodiment. In addition, in the second embodiment, since a power consumed by the voltage monitoring unit 202 and a power consumed in the configuration of the control unit 250 in which the signal Se1 is output in accordance with the signal Vd decrease, it is possible to reduce the power consumed by the internal system as compared with the first embodiment.

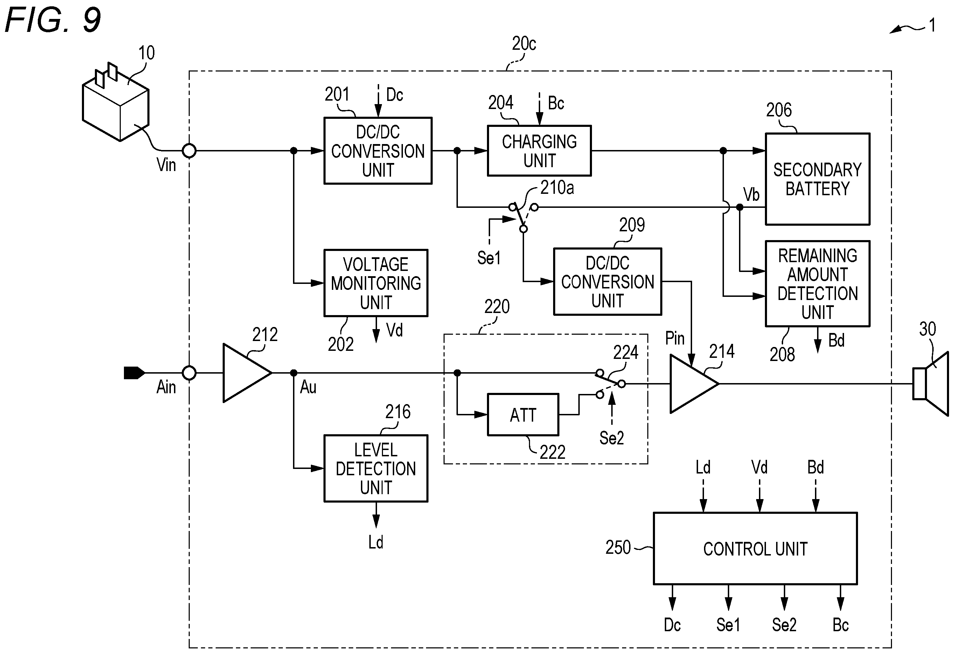

FIG. 9 is a block diagram illustrating a configuration of the system 1 including the sound signal output device 20c according to the third embodiment. The sound signal output device 20c is different from the sound signal output device 20a according to the first embodiment in that a DC/DC conversion unit 201 is provided that converts the voltage Vin and applies a voltage to one end of the charging unit 204 and the switching unit 210a, a DC/DC conversion unit 209 is provided that converts a voltage selected by the switching unit 210a and applies a voltage to the power supply input terminal Pin of the power amplifier 214, and the control unit 250 outputs a signal Dc.

The DC/DC conversion unit 201 converts the voltage Vin output from the AC adapter 10 into a charging voltage for the secondary battery 206. The DC/DC conversion unit 201 stops a conversion operation for the voltage in accordance with an instruction of the signal Dc.

The DC/DC conversion unit 209 converts the voltage selected by the switching unit 210a into a power supply voltage of the power amplifier 214 and applies the power supply voltage to the power supply input terminal Pin.

When the secondary battery 206 is selected as the power source of the power amplifier 214, the control unit 250 outputs the signal Dc for instructing the DC/DC conversion unit 201 to stop the conversion operation.

According to the third embodiment, even when the voltage Vin output from the AC adapter 10 is different from the charging voltage for the secondary battery 206, it is possible to cope with the difference by the voltage conversion executed by the DC/DC conversion unit 201.

In addition, even when the voltage Vin output from the AC adapter 10 or the voltage Vb output from the secondary battery 206 is different from the power supply voltage of the power amplifier 214, it is possible to cope with the difference by the voltage conversion executed by the DC/DC conversion unit 209.

Therefore, various types of the AC adapter 10 and the secondary battery 206 can be applied.

Further, in the third embodiment, when the power source of the power amplifier 214 is the secondary battery 206, the DC/DC conversion unit 201 stops the conversion operation for the voltage in accordance with the instruction of the signal Dc, so that a power consumed by the DC/DC conversion unit 201 can be reduced.

In the third embodiment, the DC/DC conversion unit 209 is configured to always execute the conversion operation for the voltage, but may be configured to stop the conversion operation for the voltage in the charging mode. That is, the DC/DC conversion unit 209 may stop the conversion operation for the voltage in accordance with an instruction of a predetermined signal from the control unit 250. According to this configuration, when the operation mode transitions to the charging mode, it is possible to reduce a power consumed by the DC/DC conversion unit 209 and to charge the secondary battery 206 accordingly.

In the above-described first to third embodiments (hereinafter referred to as "embodiments and the like"), various modifications or applications can be made as follows. Specific aspects of modifications that can be applied to the embodiment will be exemplified below. Two or more aspects freely selected from the following examples may be combined within a mutually consistent range.

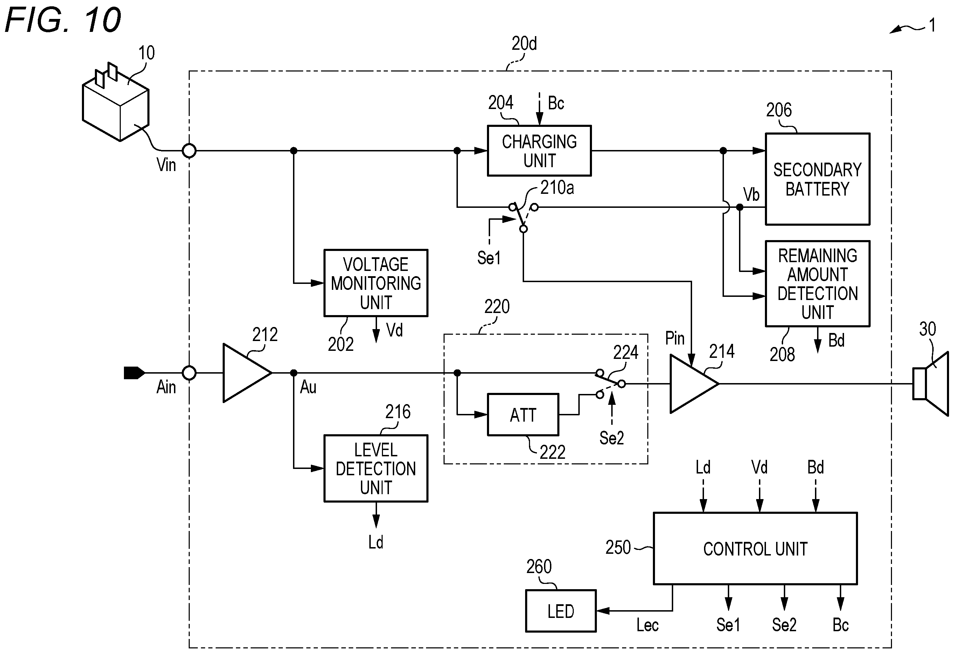

FIG. 10 is a block diagram illustrating a configuration of the system 1 including a sound signal output device 20d according to a modification.

The sound signal output device 20d is an example in which, for example, the sound signal output device 20a according to the first embodiment has a function of indicating the remaining amount of the secondary battery 206 to a user.

In the sound signal output device 20d, an LED 260 that can be visually recognized by the user is provided, and the control unit 250 controls, in accordance with the battery remaining amount indicated by the signal Bd, a light emission state of the LED 260 based on a signal Lec. The LED 260 can emit red, blue, and green light, for example.

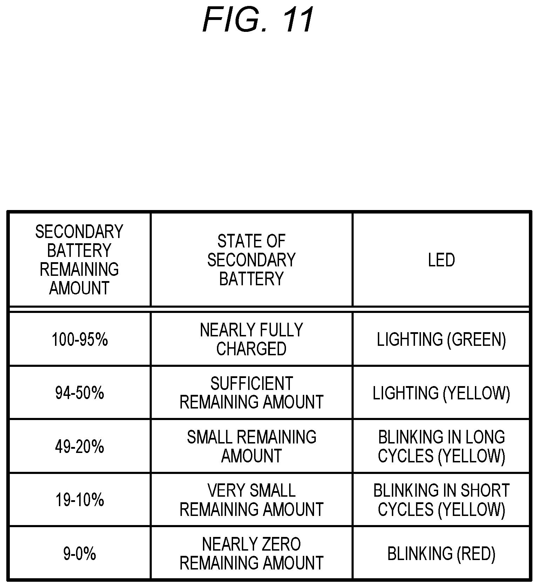

FIG. 11 is a diagram illustrating emission colors and blinking cycles of the LED 260 in accordance with the battery remaining amount.

The user can easily grasp a current operation mode of the sound signal output device 20d together with the remaining amount of the secondary battery 206 by visually recognizing the LED 260. For example, when the sound signal Au is output from the speaker 30, it is difficult for the user to understand whether the current operation mode is the normal operation mode or the output limit mode even when the user listens to only the sound. On the other hand, the user visually recognizes the LED 260, and can easily understand that the current operation mode is the output limit mode when the LED 260 blinks in red, and that the current operation mode is the normal operation mode when the LED 260 is lit in other modes.

Although FIG. 10 is an example in which the LED 260 is provided in the sound signal output device 20a according to the first embodiment, the LED 260 may be provided in the sound signal output device 20b according to the second embodiment or the sound signal output device 20c according to the third embodiment.

In the embodiment and the like, the secondary battery 206 is charged in the case of the output limit mode or the charging mode. Specifically, the secondary battery 206 is charged when the level of the sound signal Au is equal to or larger than the threshold level Lth1 and the remaining amount of the secondary battery 206 is smaller than the threshold remaining amount Bth1 or when the state in which the level of the sound signal Au is smaller than the threshold level Lth1 continues for a certain period of time. The present disclosure is not limited to this, for example, when the voltage Vin is equal to or larger than the threshold voltage Vth2 based on the signal Vd, the control unit 250 may cause the charging unit 204 to charge the secondary battery 206. In this configuration, the charging condition of the secondary battery 206 may also include a condition that the level of the sound signal Au is smaller than the threshold level Lth1 or a condition that the state in which the level of the sound signal Au is smaller than the threshold level Lth1 continues for a certain period of time in addition to the condition that the voltage Vin is equal to or larger than the threshold voltage Vth2.

In the first or third embodiment, the voltage monitoring unit 202 is configured to monitor the voltage applied to the jack of the sound signal output device 20a, but is not limited to this configuration.

For example, although not particularly illustrated, the voltage monitoring unit 202 may monitor the voltage applied to the power supply input terminal Pin of the power amplifier 214. The control unit 250 may determine whether the voltage is equal to or larger than a predetermined threshold voltage, and may select the voltage Vin output from the AC adapter 10 or the voltage Vb from the secondary battery 206 as the power source of the power amplifier 214 (that is, the voltage applied to the power supply input terminal Pin) based on the determination result.

In the configuration in which the voltage monitoring unit 202 monitors the voltage applied to the power supply input terminal Pin, the power supply voltage of the power amplifier 214 can be accurately detected without being affected by a voltage drop due to the switching unit 210a or a wiring resistance. As described above, since the power consumed by the elements other than the power amplifier 214 is substantially constant, the threshold voltage with respect to the power supply voltage of the power amplifier 214 can be set based on the rated output power of the AC adapter 10, the power consumed by the elements other than the power amplifier 214, and the like. In this case, the control unit 250 can accurately select the power source of the power amplifier 214 based on the accurately detected power supply voltage of the power amplifier 214.

Further, even in the configuration in which the voltage monitoring unit 202 monitors the voltage applied to the power supply input terminal Pin, the voltage Vin output from the AC adapter 10 can be detected by correcting the voltage applied to the power supply input terminal Pin by an amount of the voltage drop due to the switching unit 210a or the wiring resistance. The control unit 250 may compare the voltage Vin detected in this manner with the threshold voltage Vthl.

From the above-described description, aspects of the present disclosure can be understood, for example, as follows.

In Aspect 1 of the present disclosure, there is provided a sound signal output device includes: a charger configured to control charging of a secondary battery using an input power from an external power supply; and a switch configured to switch a power source of an amplifier, the amplifier being configured to amplify a sound signal, to select either the external power supply or the secondary battery, in which in response to the input power exceeding a predetermined power due to an increase in power consumption of the amplifier in a state in which the external power supply is selected as the power source, the switch is configured to switch the power source from the external power supply to the secondary battery.

According to the sound signal output device according to Aspect 1, since the power source is switched from the external power supply to the secondary battery in response to the input power exceeding the predetermined power due to the increase in the power consumption of the amplifier in the state in which the power source of the amplifier is the external power supply, amplification of the sound signal can be continued without interruption.

The charging unit 204 is an example of the "charger", the switching unit 210a, 210b is an example of the "switch". The AC adapter 10 is an example of the "external power supply", and the power amplifier 214 is an example of the "amplifier". The "input power" is a power input into the sound signal output device from the external power supply, and includes not only a power consumed by the amplifier but also a power consumption by elements other than the amplifier. The "predetermined power" is, for example, a threshold power, which is a power corresponding to a rated output power of the "external power supply". However, since an error is allowed for the rated output power, the "predetermined power" is a power that takes the error into account in the rated output power of the "external power supply".

In Aspect 2, there is provided the sound signal output device according to Aspect 1, in which in response to the external power supply not being connected or the external power supply not being normal, the switch is configured to select the secondary battery as the power source.

According to the sound signal output device according to Aspect 2, amplification of the sound signal can be continued even in the case in which the external power supply is not connected or in the case in which the external power supply is not normal.

It should be noted that "in response to ... not being connected" refers to a case in which the external power supply is not connected to the sound signal output device, and "in response to ... not being normal" refers to, for example, a case in which a failure occurs, such as a case in which the external power supply is connected to the sound signal output device, but the external power supply does not output a rated power.

In Aspect 3, there is provided the sound signal output device according to Aspect 1, further including: a monitor configured to monitor an input voltage from the external power supply; and a controller configured to control, in accordance with the input voltage monitored by the monitor, switching of the power source executed by the switch, in which in response to the input voltage monitored by the monitor being smaller than a first voltage, the controller is configured to: determine that the input power exceeds the predetermined power; and control the switch to switch the power source from the external power supply to the secondary battery.

According to the sound signal output device according to Aspect 3, in the case in which the input voltage is smaller than the first voltage, it is determined that the input power exceeds the predetermined power. The voltage monitoring unit 202 is an example of the "monitoring unit", the control unit 250 is an example of the "controller", and the threshold voltage Vth1 is an example of the "first voltage".

In Aspect 4, there is provided the sound signal output device according to Aspect 3, in which the first voltage is a voltage that is smaller than a lower limit value of a rated output voltage of the external power supply and is equal to or larger than a voltage at which a protection circuit incorporated in the external power supply operates.

The "lower limit value of the rated output voltage" refers to a lower limit value of a voltage range in which the external power supply can stably output the power. For example, when the rated output voltage is 24 V ± 5%, the lower limit value of the rated output voltage is 23.4 V.

The "protection circuit" is a circuit that blocks an output from the external power supply to protect the external power supply, and is incorporated in the external power supply. The external power supply may be of a type in which a time lag is set before the protection circuit operates or a heat sink for releasing temporary heat generation is provided in order to withstand a temporary overload, but is not limited to this type.

In Aspect 5, there is provided the sound signal output device according to Aspect 1, further including: a level detector configured to detect a level of the sound signal; and a controller configured to control the charger in accordance with the level detected by the level detector, in which the controller is configured to control the charger to charge the secondary battery a case in which the level detected by the level detector is smaller than a first level.

According to the sound signal output device according to Aspect 5, the secondary battery is charged in the case in which the level of the sound signal is smaller than the first level. The level detection unit 216 is an example of the "level detector", and the threshold level Lth1 is an example of the "first level".

In Aspect 6, there is provided the sound signal output device according to Aspect 1, further including: a remaining amount detector configured to detect a remaining amount of the secondary battery; and an attenuator configured to attenuate the sound signal and to input the attenuated sound signal into the amplifier in response to the remaining amount detected by the remaining amount detector being smaller than a first amount.

According to the sound signal output device according to Aspect 6, in the case in which the remaining amount of the secondary battery is smaller than the first amount, the sound signal is attenuated and input into the amplifier, so that the amplification of the sound signal can be continued without interruption, and a power consumed by the amplifier can be reduced. The remaining amount detection unit 208 is an example of the "remaining amount detector", the attenuation unit 220 is an example of the "attenuator", and the threshold remaining amount Bth1 is an example of the "first amount".

In Aspect 7, there is provided the sound signal output device according to specific Aspect 6, further including: a controller configured to control the charger in accordance with the remaining amount detected by the remaining amount detector, in which the controller is configured to control the charger to charge the secondary battery in response to the remaining amount detected by the remaining amount detector being smaller than the first amount.

According to the sound signal output device according to Aspect 7, the secondary battery is charged in the case in which the remaining amount of the secondary battery is smaller than the first amount.

In Aspect 8, there is provided the sound signal output device according to Aspect 1, further including: a level detector configured to detect a level of the sound signal; and a controller configured to control, in accordance with the level detected by the level detector, switching of the power source executed by the switch, in which the controller is configured to determine that the input power exceeds the predetermined power in response to the level detected by the level detector being equal to or larger than a second level.

According to the sound signal output device according to Aspect 8, the amplification of the sound signal can be continued even in the case in which the level of the sound signal is equal to or larger than the second level. The threshold level Lth2 is an example of the "second level".

In Aspect 9, there is provided the sound signal output device according to Aspect 1, further including: a level detector configured to detect a level of the sound signal; a remaining amount detector configured to detect a remaining amount of the secondary battery; and a controller configured to control the charger in accordance with the level detected by the level detector and the remaining amount detected by the remaining amount detector, in which in response to the level detected by the level detector being smaller than a first level, the controller is configured to: control the charger to charge the secondary battery in response to the remaining amount detected by the remaining amount detector being smaller than a second amount; and control the charger not to charge the secondary battery in response to the remaining amount being equal to or larger than the second amount.

According to the sound signal output device according to Aspect 9, in the case in which the level of the sound signal is smaller than the first level, the secondary battery is charged in the case in which the remaining amount of the secondary battery is smaller than the second amount, and the secondary battery is not charged in the case in which the remaining amount is equal to or larger than the second amount. That is, even in the case in which the level of the sound signal is smaller than the first level, the charging of the secondary battery is prevented in the case in which the remaining amount of the secondary battery is equal to or larger than the second amount, and therefore, deterioration of the secondary battery is prevented. The threshold remaining amount Bth2 is an example of the "second amount".

In Aspect 10, there is provided the sound signal output device according to Aspect 1, further including: a monitor configured to monitor an input voltage from the external power supply, in which the secondary battery is charged in response to the input voltage monitored by the monitor being equal to or larger than a second voltage.

According to the sound signal output device according to Aspect 10, the secondary battery is charged in the case in which the input voltage from the external power supply is equal to or larger than the second voltage. The threshold voltage Vth2 is an example of the "second voltage".

The sound signal output device according to Aspect 1 can be understood as the following sound signal output method. That is, a sound signal output method according to Aspect 11 is a method for controlling charging of a secondary battery using an input power from an external power supply and switching a power source of an amplifier, the amplifier being configured to amplify a sound signal, to select either the external power supply or the secondary battery, the sound signal output method including: switching the power source from the external power supply to the secondary battery in response to the input power exceeding a predetermined power due to an increase in power consumption of the amplifier in a state in which the external power supply is selected as the power source.

In Aspect 12, there is provided the sound signal output method according to Aspect 11, further including: selecting the secondary battery as the power source in response to the external power supply not being connected or the external power supply not being normal.

In Aspect 13, there is provided the sound signal output method according to Aspect 11, further including: monitoring, by a voltage monitor, an input voltage from the external power supply; controlling, by a controller, switching of the power source executed by the switch in accordance with the input voltage monitored by the voltage monitor; and determining, by the controller, that the input power exceeds the predetermined power, and controlling the switch to switch the power source from the external power supply to the secondary battery, in response to the input voltage monitored by the voltage monitor being smaller than a first voltage.

In Aspect 14, there is provided the sound signal output method according to Aspect 13, wherein the first voltage is a voltage that is smaller than a lower limit value of a rated output voltage of the external power supply and is equal to or larger than a voltage at which a protection circuit incorporated in the external power supply operates.

In Aspect 15, there is provided the sound signal output method according to Aspect 11, further including: detecting, by a level detector, a level of the sound signal; and controlling, by a controller, a charger in accordance with the level detected by the level detector, to charge the secondary battery in response to the level detected by the level detector being smaller than a first level.

In Aspect 16, there is provided the sound signal output method according to Aspect 11, further including: detecting, by a remaining amount detector, a remaining amount of the secondary battery; and attenuating, by an attenuator, the sound signal and inputting the attenuated sound signal into the amplifier in response to the remaining amount detected by the remaining amount detector being smaller than a first amount.

In Aspect 17, there is provided the sound signal output method according to Aspect 16, further including: controlling, by a controller, a charger in accordance with the remaining amount detected by the remaining amount detector, to charge the secondary battery in response to the remaining amount detected by the remaining amount detector being smaller than the first amount.

In Aspect 18, there is provided the sound signal output method according to Aspect 11, further including: detecting, by a level detector, a level of the sound signal; controlling, by a controller, switching of the power source executed by the switch in accordance with the level detected by the level detector; and determining, by the controller, that the input power exceeds the predetermined power in response to the level detected by the level detector being equal to or larger than a second level.

In Aspect 19, there is provided the sound signal output method according to Aspect 11, further including: detecting, by a level detector, a level of the sound signal; detecting, by a remaining amount detector, a remaining amount of the secondary battery; controlling, by a controller, a charger in accordance with the level detected by the level detector and the remaining amount detected by the remaining amount detector; and in response to the level detected by the level detector being smaller than a first level: controlling, by the controller, the charger to charge the secondary battery in response to the remaining amount detected by the remaining amount detector being smaller than a second amount; or controlling, by the controller, the charger not to charge the secondary battery in response to the remaining amount being equal to or larger than the second amount.

In Aspect 20, there is provided the sound signal output method according to Aspect 11, further including: monitoring, by a voltage monitor, an input voltage from the external power supply; and charging the secondary battery in response to the input voltage monitored by the voltage monitor being equal to or larger than a second voltage.

## Claims

1. A sound signal output device (20a; 20b; 20c; 20d) comprising:
a charger (204) configured to control charging of a secondary battery (206) using an input power from an external power supply (10); and
a switch (210a; 210b) configured to switch a power source of an amplifier (214), the amplifier (214) being configured to amplify a sound signal, to select either the external power supply (10) or the secondary battery (206), wherein
in response to the input power exceeding a predetermined power due to an increase in power consumption of the amplifier (214) in a state in which the external power supply (10) is selected as the power source, the switch (210a; 210b) is configured to switch the power source from the external power supply (10) to the secondary battery (206).

2. The sound signal output device (20a; 20b; 20c; 20d) according to claim 1, wherein
in response to the external power supply (10) not being connected or the external power supply (10) not being normal, the switch (210a; 210b) is configured to select the secondary battery (206) as the power source.

3. The sound signal output device (20a; 20c; 20d) according to claim 1, further comprising:
a voltage monitor (202) configured to monitor an input voltage (Vin) from the external power supply (10); and
a controller (250) configured to control, in accordance with the input voltage (Vin) monitored by the voltage monitor (202), switching of the power source executed by the switch (210a), wherein
in response to the input voltage (Vin) monitored by the voltage monitor (202) being smaller than a first voltage (Vthl), the controller (250) is configured to:
determine that the input power exceeds the predetermined power; and
control the switch (210a) to switch the power source from the external power supply (10) to the secondary battery (206).

4. The sound signal output device (20a; 20c; 20d) according to claim 3, wherein
the first voltage (Vthl) is a voltage that is smaller than a lower limit value of a rated output voltage of the external power supply (10) and is equal to or larger than a voltage at which a protection circuit incorporated in the external power supply (10) operates.

5. The sound signal output device (20a; 20b; 20c; 20d) according to claim 1, further comprising:
a level detector (216) configured to detect a level of the sound signal; and
a controller (250) configured to control the charger (204) in accordance with the level detected by the level detector (216), wherein
the controller (250) is configured to control the charger (204) to charge the secondary battery (206) in response to the level detected by the level detector (216) being smaller than a first level (Lthl).

6. The sound signal output device (20a; 20b; 20c; 20d) according to claim 1, further comprising:
a remaining amount detector (208) configured to detect a remaining amount of the secondary battery (206); and
an attenuator (220) configured to attenuate the sound signal and to input the attenuated sound signal into the amplifier (214) in response to the remaining amount detected by the remaining amount detector (208) being smaller than a first amount (Bth1).

7. The sound signal output device (20a; 20b; 20c; 20d) according to claim 6, further comprising:
a controller (250) configured to control the charger (204) in accordance with the remaining amount detected by the remaining amount detector (208), wherein
the controller (250) is configured to control the charger (204) to charge the secondary battery (206) in response to the remaining amount detected by the remaining amount detector (208) being smaller than the first amount (Bth1).

8. The sound signal output device (20a; 20b; 20c; 20d) according to claim 1, further comprising:
a level detector (216) configured to detect a level of the sound signal; and
a controller (250) configured to control, in accordance with the level detected by the level detector (216), switching of the power source executed by the switch (210a; 210b), wherein
the controller (250) is configured to determine that the input power exceeds the predetermined power in response to the level detected by the level detector (216) being equal to or larger than a second level (Lth2).

9. The sound signal output device (20a; 20b; 20c; 20d) according to claim 1, further comprising:
a level detector (216) configured to detect a level of the sound signal;
a remaining amount detector (208) configured to detect a remaining amount of the secondary battery (206); and
a controller (250) configured to control the charger (204) in accordance with the level detected by the level detector (216) and the remaining amount detected by the remaining amount detector (208), wherein
in response to the level detected by the level detector (216) being smaller than a first level (Lthl), the controller (250) is configured to:
control the charger (204) to charge the secondary battery (206) in response to the remaining amount detected by the remaining amount detector (208) being smaller than a second amount (Bth2); and
control the charger (204) not to charge the secondary battery (206) in response to the remaining amount being equal to or larger than the second amount (Bth2).

10. The sound signal output device (20a; 20c; 20d) according to claim 1, further comprising:
a voltage monitor (202) configured to monitor an input voltage (Vin) from the external power supply (10), wherein
the secondary battery (206) is charged in response to the input voltage (Vin) monitored by the voltage monitor (202) being equal to or larger than a second voltage (Vth2).

11. A sound signal output method for controlling charging of a secondary battery (206) using an input power from an external power supply (10) and switching a power source of an amplifier (214), the amplifier (214) being configured to amplify a sound signal, to select either the external power supply (10) or the secondary battery (206), the sound signal output method comprising:
switching the power source from the external power supply (10) to the secondary battery (206) in response to the input power exceeding a predetermined power due to an increase in power consumption of the amplifier (214) in a state in which the external power supply (10) is selected as the power source.
